# EUROPÄISCHE PATENTSCHRIFT

(11) **EP 3 665 710 B1**
(45) Veröffentlichungstag und Bekanntmachung des Hinweises auf die Patenterteilung: **26.10.2022**
(21) Anmeldenummer: 18779216.3
(22) Anmeldetag: 12.09.2018
(51) Int. Cl.: H01F 27/29, H01F 27/00, H01F 27/40, H01F 30/10

(54) **ANORDNUNG ZUM ANSCHLUSS AN EIN HOCHSPANNUNGSNETZ MIT MEHREREN EINPHASIGEN TRANSFORMATOREN**
ASSEMBLY FOR CONNECTING TO A HIGH-VOLTAGE GRID WITH A PLURALITY OF MONOPHASE TRANSFORMERS
DISPOSITIF DESTINÉ À ÊTRE RACCORDÉ À UN RÉSEAU À HAUTE TENSION AVEC UNE PLURALITÉ DE TRANSFORMATEURS MONOPHASÉS

(30) Priorität: 06.10.2017 DE 102017217783
(43) Veröffentlichungstag der Anmeldung: 17.06.2020
(73) Patentinhaber: Siemens Energy Global GmbH & Co. KG, 81739 München (DE)
(72) Erfinder: ETTL, Christian, 8160 Weiz (AT)
(86) Internationale Anmeldenummer: PCT/EP2018/074532
(87) Internationale Veröffentlichungsnummer: WO 2019/068438

(56) Entgegenhaltungen:
- DE-A1-102010 062 605
- GB-A- 2 464 192

## Beschreibung

Die Erfindung betrifft eine Anordnung zum Anschluss an ein Hochspannungsnetz mit mehreren einphasigen Transformatoren, die jeweils einen mit einem Fluid befüllten Transformatortank aufweisen, in dem ein Kern mit wenigstens einer Wicklung angeordnet ist, wobei die Wicklungen der einphasigen Transformatoren zumindest teilweise unter Ausbildung eines Sternpunktes miteinander verbunden sind.

Eine solche Anordnung ist dem Fachmann aus der GB 2 464 192 A bekannt. Dort ist eine Anordnung von Generatortransformatoren offenbart, die wie üblich einphasig ausgebildet sind. Dabei dienen die einphasigen Transformatoren zum Umwandeln der kraftwerksseitig bereitgestellten Mittelspannung auf eine Hochspannung. Jeder der einphasigen Transformatoren verfügt über einen Transformatorkessel oder -tank, in dem ein Kern mit wenigstens einer Wicklung angeordnet ist. Dabei ist der Transformatortank mit einem Isolierfluid befüllt, so dass die beim Betrieb auf Hochspannung liegenden Bauteile durch das Isolierfluid isoliert und gekühlt sind.

Die DE 10 2010 062 605 A1 offenbart eine Stromwandlerbaugruppe, die drei turmartig aufgebaute Stapel aus Wicklungskörpern aufweist. Die Wicklungskörper sind zumindest teilweise über eine Kontaktierungsstelle mit dem Hochspannungsleiter einer Durchführung verbunden, die fest an einem Gehäuse der Stromwanlderbaugruppe montiert sind.

Einphasige Transformatoren sind dem Fachmann aus der Praxis bekannt und werden beispielsweise in der Hochspannungsgleichstromübertragung eingesetzt, wobei für jede Phase des Wechselspannungsnetzes ein einphasiger Transformator vorgesehen ist. Jeder einphasige Transformator verfügt über einen Transformatortank, in dem ein aus Kern und Wicklung bestehendes Aktivteil angeordnet ist. Zur Kühlung und elektrischen Isolation des Aktivteils dient eine Isolierflüssigkeit, mit welcher der Transformatortank befüllt ist. Die Wicklungen der einphasigen Transformatoren sind elektrisch miteinander verschaltet, wobei bei einigen Anwendungen ein Sternpunkt ausgebildet wird. Die Sternpunktbildung erfolgt in der Regel über eine Erdverbindung der entsprechenden Wicklungen.

Der vorbekannten Anordnung haftet der Nachteil an, dass die über den Sternpunkt geführten Ausgleichsströme über ein fest montiertes Schienensystem der jeweiligen Umspannstation fließen müssen. Die Ableitung des Sternpunktstromes über ein solches Erdungsnetz hat jedoch ein Betriebsrisiko im Gefolge, da es in der Regel für die möglichen hohen Ausgleichsströme gar nicht ausgelegt ist.

Die Erfindung sieht eine Anordnung zum Anschluss an ein Hochspannungsnetz mit mehreren einphasigen Transformatoren gemäß Anspruch 1 vor. Vorteilhafte Ausführungsformen sind in den abhängigen Ansprüchen definiert.

Aufgabe der Erfindung ist es, eine Anordnung der eingangs genannten Art bereitzustellen, die schnell vor Ort montiert werden kann, wobei gleichzeitig ein sicherer Strompfad für die Ausgleichs- und Erdungsströme bereit gestellt ist.

Die Erfindung löst diese Aufgabe dadurch, dass die Wicklungen zur Ausbildung des Sternpunktes über einen Sternpunktleiter miteinander verbunden sind, wobei der Sternpunktleiter isoliert an einem Transformatortank gehalten ist.

Erfindungsgemäß ist ein Sternpunktleiter vorgesehen, der direkt am Transformatortank befestigt ist. Ein von den jeweiligen Transformatoren unabhängiges Bauteil ist somit im Rahmen der Erfindung überflüssig geworden. Darüber hinaus ist das Fließen von Ausgleichsströmen zwischen den Phasen eines Schienensystems der Umspannstation vermieden. Der Sternpunktleiter ist erfindungsgemäß isoliert an dem Transformatortank gehalten. Die isolierte Halterung ermöglicht, dass der Transformatortank auch während des Betriebs der Anordnung auf Erdpotential liegt, wobei der Sternpunktleiter ein fliegendes Potential aufweisen kann oder aber separat geerdet ist.

Die Erfindung ist insbesondere dann vorteilhaft, wenn die erfindungsgemäße Anordnung für einen temporären Ersatz eines defekten Transformators vorgesehen ist. Handelt es sich bei dem defekten Transformator um einen dreiphasigen Transformator, ist ein Schienensystem im Umspannwerk zum Führen der Ausgleichsströme überhaupt nicht vorgesehen und müsste daher aufwändig installiert werden. Sollen drei einphasige Transformatoren durch die erfindungsgemäße Anordnung ersetzt werden, ist schon der Anschluss der Wicklungen an ein bestehendes Schienensystem aufwändig, da der Aufstellort der "neuen" einphasigen Transformatoren vor dem Entfernen der auszutauschenden Transformatoren von dem jeweiligen Platzangebot vor Ort abhängig ist. Darüber hinaus, ist die Auslegung des bestehenden Schienensystems nicht an die nach dem Austausch möglichen Ausgleichströme angepasst.

Der Sternpunktleiter kann im Rahmen der Erfindung grundsätzlich beliebig ausgestaltet sein. Erfindungsgemäß besteht der Sternpunktleiter aus einem Material mit einer hohen elektrischen Leitfähigkeit und bevorzugt aus Metall oder einer metallischen Verbindung. Bei einer Variante besteht der Sternpunktleiter aus Kupfer.

Zweckmäßigerweise ist jeder Sternpunktleiter als Sammelschiene ausgeführt, die mittels Isolatoren an dem Transformatortank befestigt ist. Die Isolatoren sind vorteilhafterweise für Spannungen im Bereich von 5 bis 20 kV ausgelegt, insbesondere 10 kV, so dass es im Rahmen der Erfindung möglich geworden ist, dass der Sternpunktleiter ein von dem Potential des Transformatortanks abweichendes elektrisches Potential aufweist. Eine Sammelschiene ist ein mechanisch festes Bauteil, das im Gegensatz zu Drahtleitern oder Kabeln starr also nicht flexibel ist. Eine feste Sammelschiene stellt den notwendigen mechanischen Halt für die notwendigen Anschlüsse mit den jeweiligen Wicklungsenden bereit.

Gemäß einer bevorzugten Ausgestaltung der Erfindung verfügt jeder Transformatortank über eine Sammelschiene. Gemäß dieser Weiterentwicklung der Erfindung kann der Herstellungsprozess der einphasigen Transformatoren vollkommen gleich ausgestaltet werden. Jeder Transformatortank weist ja den gleichen Sternpunktleiter auf, der beispielsweise über Isolatoren, Stützer oder sonstige elektrisch nicht leitende Haltemittel an dem jeweiligen Transformatortank befestigt ist. Hierdurch werden die Kosten gesenkt. Zur Bildung des Sternpunktes der Wicklungen wird eine der Sternpunktleiter mit allen Wicklungen verbunden, während die anderen Sternpunktleiter bei der jeweiligen Anwendung ungenutzt bleiben. Auf diese Art und Weise kann der für die jeweilige Anwendung am besten geeignetste Sternpunktleiter ausgewählt werden. Dies vereinfacht und beschleunigt die Montage der Anordnung vor Ort. Die erfindungsgemäße Anordnung ist somit noch flexibel einsetzbar.

Gemäß einer bevorzugten Variante der Erfindung weist jeder Transformatortank wenigstens eine Sternpunktsteckbuchse auf, die über einen isoliert am Transformatortank gehaltenen Sternpunktkontakt verfügt, wobei der Sternpunktkontakt mit wenigstens einer der Wicklungen und über eine Kabelverbindung mit dem Sternpunktleiter verbunden ist. Gemäß dieser Variante der Erfindung werden die Wicklungen über eine steckbare Kabelverbindung miteinander verbunden. Der Sternpunkt kann so schnell vor Ort bereitgestellt werden. Zunächst werden die einphasigen Transformatoren auf dem Gelände je nach Platzangebot verteilt aufgestellt. Anschließend werden die jeweiligen Sternpunktkabel mit ihren steckbaren Kabelendverschlüssen in die Sternpunktsteckbuchse eingeführt. Das Sternpunktkabel weist an seinem vom Kabelendverschluss abgewandten Ende beispielsweise einen einfachen Kabelschuh auf, mit welchem er an dem starren Sternpunktleiter beispielsweise durch einfaches Verschrauben sicher und zuverlässig befestigt werden kann.

Der Kabelstecker oder - mit anderen Worten - der Kabelendverschluss an einem Ende des Sternpunktkabels ist in der Regel formkomplementär oder passend zur Sternpunktsteckbuchse ausgebildet. Die Sternpunktsteckbuchse bildet einen Innenkonus aus, der von einer aus einem nicht leitenden Material gefertigten Buchsenwand begrenzt ist. Am geschlossenen Ende des Innenkonus ist der Sternpunktkontakt isoliert gehalten. Dabei ist der elektrisch gut leitende Sternpunktkontakt mit dem Wicklungsende der Wicklung des jeweiligen einphasigen Transformators verbunden, so dass er bei Betrieb auf einem Hochspannungspotential liegt. Der Kabelendverschluss oder mit anderen Worten der Kabelstecker bindet einen Außenkonus aus, an dessen freien Ende ein elektrisch leitender Einführkontakt vorgesehen ist, der in der eingesteckten Stellung in Kontakt mit dem Sternpunktkontakt der Sternpunktsteckbuchse steht. Der Einführkontakt ist ferner mit dem Innenleiter eines Sternpunktkabels verbunden.

Gemäß einer weiteren Ausführung der Erfindung ist der Sternpunktleiter berührungssicher unterhalb einer an dem Transformatortank befestigten Abschirmung angeordnet. Die Abschirmung ist so oberhalb des Sternpunktleiters angeordnet und übergreift den Sternpunktleiter, dass dieser vor Wettereinflüssen, Verschmutzung und dergleichen geschützt ist. Darüber hinaus ist sichergestellt, dass der Sternpunktleiter nicht unbeabsichtigt von Bedienpersonal berührt werden kann. Unerwünschte Unfälle beim Betrieb der Anordnung sind so vermieden. Die Abschirmung ist elektrisch mit dem Transformatortank, nicht aber mit dem Sternpunktleiter Verbunden.

Zweckmäßigerweise weist jeder Transformatortank zwei Sternpunktsteckbuchsen auf, deren Sternpunktkontakte mit dem gleichen Ende der jeweiligen Wicklung verbunden sind. Dabei sind beide Sternpunktsteckbuchsen über jeweils ein Kabel mit dem Sternpunktleiter verbunden. Gemäß dieser vorteilhaften Weiterentwicklung ist das jeweilige Wicklungsende über zwei Sternpunktkabel an den Sternpunktleiter angeschlossen. An jedem Transformatortank sind dazu zwei Sternpunktsteckbuchsen ausgebildet, so dass beide Sternpunktkabel schnell und einfach mit dem Wicklungsende der jeweiligen Wicklung verbunden werden können. Im Übrigen gelten die weiter oben gemachten Ausführungen hier entsprechend. Die doppelte Verbindung ermöglicht zum Einen das Führen höherer Ausgleichsströme und stellt darüber hinaus sicher, dass die Sternpunktverbindung bei Ausfall eines Sternpunktkabels über das verbleibende Sternpunktkabel erhalten bleibt.

Gemäß einer weiteren vorteilhaften Ausgestaltung der Erfindung ist der Sternpunktleiter über ein Erdungskabel mit dem Erdpotential verbunden, wobei das Erdungskabel mit einem Stromsensor ausgerüstet ist. Gemäß dieser Weiterentwicklung werden die Nullsystemströme, die über das sich zwischen dem Erdpotentialanbindung und dem Sternpunktleiter erstreckende Erdungskabel fließen, durch den Stromsensor erfasst. Der Stromsensor stellt ausgangsseitig Messwerte bereit, die dem Nullsystemstrom entsprechen. Der Stromsensor ist zweckmäßigerweise über eine Signalleitung mit einer Schutz- und/oder Regelungseinheit verbunden, welche die sich ergebenden Messsignale der Nullsystemströme für das jeweilige Schutzkonzept verwendet. Die Signalleitung kann als kabelgeführte oder kabellose Verbindung ausgeführt sein.

Weitere zweckmäßige Ausgestaltungen und Vorteile der Erfindung sind Gegenstand der nachfolgenden Beschreibung von Ausführungsbeispielen der Erfindung unter Bezug auf die Figuren der Zeichnung, wobei gleiche Bezugszeichen auf gleichwirkende Bauteile verweisen und wobei
- Figur 1: ein Ausführungsbeispiel der erfindungsgemäßen Anordnung in einer schematischen Darstellung,
- Figur 2: einen Transformatortank mit Sternpunktsammelschiene und Sternpunktkabeln und
- Figur 3: den Sternpunktleiter gemäß Figur 2 mit einer Schutzabdeckung verdeutlichen.

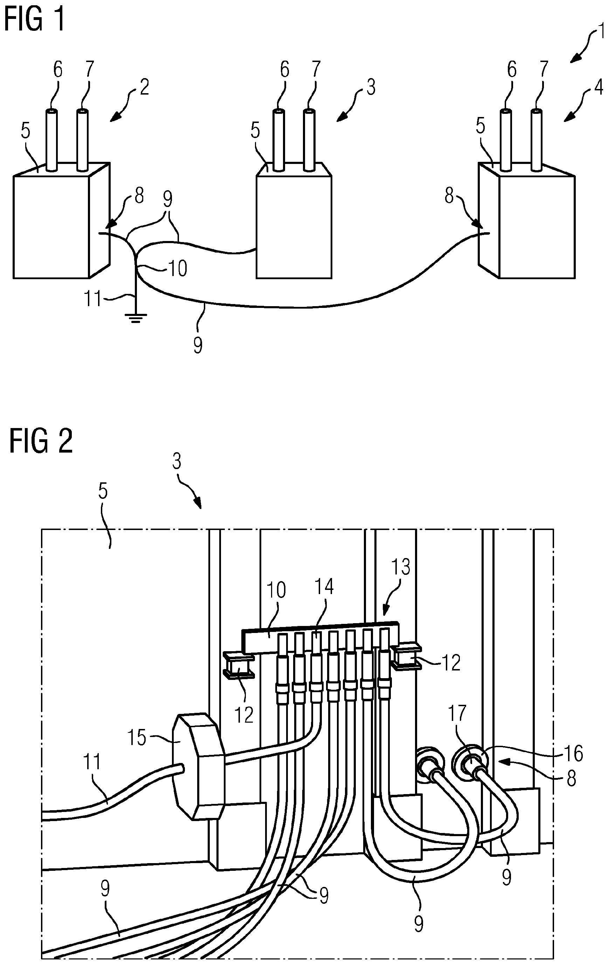

Figur 1 zeigt schematisch ein Ausführungsbeispiel der erfindungsgemäßen Anordnung 1, die drei einphasige Transformatoren 2, 3 und 4 aufweist. Dabei ist jeder einphasige Transformator 2, 3 und 4 nur schematisch durch den jeweiligen Transformatortank 5 sowie zwei Hochspannungsdurchführungen 6 und 7 dargestellt. Ferner ist eine Sternpunktsteckbuchse 8 verdeutlicht, die in der Seitenwand des Transformatortanks 5 eines jeden einphasigen Transformators 2, 3 und 4 vorgesehen ist. Die Sternpunktsteckbuchse 8 weist eine Flanschverbindung auf, mit der die Sternpunktsteckbuches 8 fluiddicht an der Seitenwandung des jeweiligen Transformatortanks 5 befestigt ist. Mit einer aus einem elektrisch nicht leitenden Material gefertigten Seitenwand, die einen Innenkonus begrenzt, erstreckt sich die Sternpunktbuchse in den Fluidraum des Transformatortanks 5 hinein und bildet dort ein geschlossenes Ende aus. An dem geschlossenen Ende ist ein elektrisch leitender Sternpunktkontakt vorgesehen, der die elektrisch nicht leitende Seitenwand durchragt. Der Sternpunktkontakt ist seinerseits mit einem Ende einer innerhalb des Transformatortanks angeordneten Wicklung verbunden, das im Folgenden als Sternpunktwicklungsende bezeichnet wird.

Die Sternpunktsteckbuchse 8 ist formkomplementär zu einem figürlich nicht dargestellten Kabelendverschluss ausgebildet, der einen Außenkonus ausbildet, an dessen freiem Ende ein elektrisch leitender Kabelkontakt ausgebildet ist, der, wenn der Kabelendverschluss in die Sternpunktsteckbuchse eingeführt ist, in Kontakt ist mit dem Sternpunktkontakt der Sternpunktbuchse 8 ist. Der Steckkontakt ist mit dem Innenleiter eines Sternpunktkabels 9 verbunden. An seiner von dem Kabelendverschluss abgewandten Seite bildet jedes Sternpunktkabel 9 einen Kabelschuh aus. Der Kabelschuh dient zur Montage des Sternpunktkabels 9 an den Sternpunktleiter 10. Die Wicklungen der einphasigen Transformatoren 3 und 4 sind auf diese Weise mit dem Sternpunktleiter 10 verbunden. Über ein Erdungskabel 11 ist der Sternpunktleiter 10 an das Erdpotential angeschlossen.

Figur 2 zeigt ein Ausführungsbeispiel eines Sternpunktleiters 10, der an einem Transformatortank 5 des einphasigen Transformators 3 mittels Isolatoren 12 befestigt ist. Die Isolatoren 12 bestehen aus einem elektrisch nicht leitenden Material, beispielsweise einem Elastomer, und sorgen für die isolierte Halterung des Sternpunktleiters 10 am Transformatortank 5. Am Sternpunktleiter 10 sind sechs Sternpunktkabel 9 befestigt. Hierzu verfügt jedes Sternpunktkabel 9 über einen Kabelschuh 13, der über eine Schraubverbindung 14 fest mit dem Sternpunktleiter 10 verschraubt ist. Darüber hinaus ist das Erdungskabel 11 erkennbar, das sich zwischen dem Sternpunktleiter 10 und einem hier nicht dargestellten Erdanschluss erstreckt. Dabei wird das Erdungskabel 11 durch einen Stromsensor 15 geführt, der zum Erfassen der über das Erdungskabel 11 fließenden Nullsystemströme eingerichtet ist.

Darüber hinaus ist in Figur 2 die Sternpunktsteckbuchse 8 mit ihrem Flanschabschnitt 16 erkennbar, in die der Kabelendverschluss 17 des jeweiligen Sternpunktkabels 9 eingeführt ist. Es ist erkennbar, dass der Transformatortank 5 des einphasigen Transformators 3 zwei Sternpunktsteckbuchsen 8 aufweist, wobei jede Sternpunktsteckbuchse 8 über ein Sternpunktkabel 9 mit der Sternpunktschiene 10 verbunden ist. Entsprechendes gilt für die einphasigen Transformatoren 2 und 4, so dass die Sternpunktschiene 10 mit dem Kabelschuh 13 von sechs Sternpunktkabeln 9 verbunden ist. Das Sternpunktwicklungsende jeder Wicklung ist also über zwei Sternpunktkabel 9 an den Sternpunktleiter 10 angeschlossen. Der Sternpunktleiter 10 ist in dem gezeigten Ausführungsbeispiel als starre Sammelschiene aus Kupfer ausgeführt.

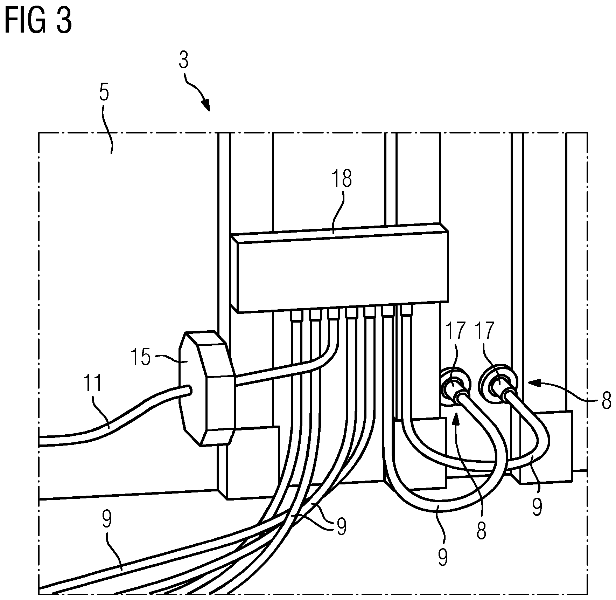

Figur 3 zeigt das Ausführungsbeispiel gemäß Figur 3, wobei jedoch die Sternpunktschiene durch eine Abschirmung 18 verdeckt ist, die oberhalb der Sternpunktschiene angeordnet ist und einen Kontakt des Personals mit der Sternpunktschiene 10 verhindern soll. Darüber hinaus schützt die Abschirmung 18 vor wetterbedingten Verunreinigungen. Die Abschirmung 18 ist elektrisch leitend mit dem Transformatortank 5 verbunden und übergreift die Sternpunktschiene, so dass ein elektrischer Kontakt zwischen Abschirmung 18 und Sternpunktschiene 19 vermieden ist.

## Patentansprüche

1. Anordnung (1) zum Anschluss an ein Hochspannungsnetz mit mehreren einphasigen Transformatoren (2,3,4), die jeweils einen mit einem Fluid befüllten Transformatortank (5) aufweisen, in dem ein Kern mit wenigstens einer Wicklung angeordnet ist,
wobei die Wicklungen der einphasigen Transformatoren (2,3,4) zumindest teilweise unter Ausbildung eines Sternpunktes miteinander verbunden sind,
**dadurch gekennzeichnet,**
**dass** die Wicklungen zur Ausbildung des Sternpunktes über einen Sternpunktleiter (10) miteinander verbunden sind,
wobei der Sternpunktleiter (10) isoliert an einem Transformatortank (5) gehalten ist.

2. Anordnung (1) nach Anspruch 1,
**dadurch gekennzeichnet,**
**dass** der Sternpunktleiter (10) eine Sammelschiene ist, die mittels Isolatoren (12) an dem Transformatortank (5) befestigt ist.

3. Anordnung (1) nach Anspruch 2,
**dadurch gekennzeichnet,**
**dass** jeder Transformatortank (5) mit einer Sammelschiene (10) ausgerüstet ist.

4. Anordnung (1) nach einem der vorhergehenden Ansprüche,
**dadurch gekennzeichnet,**
**dass** jeder Transformatortank (5) eine Sternpunktsteckbuchse (8) aufweist, die über einen isoliert am Transformatortank (5) gehaltenen Sternpunktkontakt verfügt,
wobei der Sternpunktkontakt mit wenigstens einer der Wicklungen verbunden ist und über ein Sternpunktkabel (9) mit dem Sternpunktleiter (10) verbunden ist.

5. Anordnung (1) nach dem vorhergehenden Anspruch,
**dadurch gekennzeichnet,**
**dass** jeder Transformatortank (5) zwei Sternpunktsteckbuchsen (8) aufweist, deren Sternpunktkontakte mit dem gleichen Ende der jeweiligen Wicklung verbunden sind,
wobei beide Sternpunktsteckbuchsen (8) über jeweils ein Schwerpunktkabel (9) mit dem Sternpunktleiter (16) verbunden sind.

6. Anordnung (1) nach einem der vorhergehenden Ansprüche,
**dadurch gekennzeichnet,**
**dass** der Sternpunktleiter (10) berührungssicher unterhalb einer am Transformatortank befestigten Abschirmung (18) angeordnet ist.

7. Anordnung (1) nach einem der vorhergehenden Ansprüche,
**dadurch gekennzeichnet,**
**dass** der Sternpunktleiter (10) über ein Erdungskabel (11) mit dem Erdpotenzial verbunden ist,
wobei das Erdungskabel (11) mit einem Stromsensor (15) ausgerüstet ist.

## Claims

1. Assembly (1) for connecting to a high-voltage grid, having a plurality of single-phase transformers (2, 3, 4), each of which comprises a fluid-filled transformer tank (5), in which a core having at least one winding is arranged,
wherein said windings of the single-phase transformers (2, 3, 4) are at least partly interconnected to constitute a neutral point,
**characterized in that**
the windings are interconnected by means of a neutral point conductor (10) to constitute the neutral point,
wherein the neutral point conductor (10) is retained on a transformer tank (5) in an insulated arrangement.

2. Assembly (1) according to Claim 1,
**characterized in that**
the neutral point conductor (10) is a busbar, which is fastened to the transformer tank (5) by means of insulators (12).

3. Assembly (1) according to Claim 2,
**characterized in that**
each transformer tank (5) is equipped with a busbar (10).

4. Assembly (1) according to one of the preceding claims, **characterized in that**
each transformer tank (5) comprises a neutral point socket (8), having a neutral point contact which is retained on the transformer tank (5) in an insulated arrangement,
wherein the neutral point contact is connected to at least one of the windings and, by means of a neutral point cable (9), is connected to the neutral point conductor (10).

5. Assembly (1) according to the preceding claim, **characterized in that**
each transformer tank (5) comprises two neutral point sockets (8), the neutral point contacts of which are connected to the same end of the respective winding,
wherein both neutral point sockets (8) are connected to the neutral point conductor (16) by means of one focal point cable (9) respectively.

6. Assembly (1) according to one of the preceding claims, **characterized in that**
the neutral point conductor (10) is arranged, in a contact-safe manner, under a shielding (18) which is fastened to the transformer tank.

7. Assembly (1) according to one of the preceding claims, **characterized in that**
the neutral point conductor (10) is connected to ground potential by means of a grounding cable (11),
wherein the grounding cable (11) is equipped with a current sensor (15).

## Revendications

1. Dispositif (1) à raccorder à un réseau à haute tension comprenant plusieurs transformateurs (2, 3, 4) monophasés, qui ont chacun une cuve (5) de transformateur emplie d'un fluide, dans laquelle est disposé un noyau ayant au moins un enroulement, dans lequel les enroulements des transformateurs (2, 3, 4) monophasés sont reliés entre eux au moins en partie avec constitution d'un point neutre,
**caractérisé**
**en ce que** les enroulements de constitution du point neutre sont reliés entre eux par un conducteur (10) de point neutre,
dans lequel le conducteur (10) de point neutre est maintenu de manière isolée sur une cuve (5) de transformateur.

2. Dispositif (1) suivant la revendication 1,
**caractérisé**
**en ce que** le conducteur (10) de point de neutre est un rail collecteur, qui est fixé à la cuve (5) de transformateur au moyen d'isolateurs (12).

3. Dispositif (1) suivant la revendication 2,
**caractérisé**
**en ce que** chaque cuve (5) de transformateur est équipée d'un rail (10) collecteur.

4. Dispositif (1) suivant l'une des revendications précédentes, **caractérisé**
**en ce que** chaque cuve (5) de transformateur a une fiche (8) femelle de point neutre, qui dispose d'un contact de point neutre maintenu de manière isolé sur la cuve (5) de transformateur,
dans lequel le contact de point neutre est relié à au moins l'un des enroulements et est relié au conducteur (10) de point neutre par un câble (9) de point neutre.

5. Dispositif (1) suivant la revendication précédente, **caractérisé**
**en ce que** chaque cuve (5) de transformateur a deux fiches (8) femelles de point neutre, dont les contacts de point de neutre sont reliés à la même extrémité de l'enroulement respectif,
dans lequel les deux fiches (8) femelle de point neutre sont reliées au conducteur (16) de point neutre par respectivement un câble (9) de point neutre.

6. Dispositif (1) suivant l'une des revendications précédentes, **caractérisé**
**en ce que** le conducteur (10) de point neutre est disposé, en étant protégé du toucher, en dessous d'un blindage (18) fixé à la cuve de transformateur.

7. Dispositif (1) suivant l'une des revendications précédentes, **caractérisé**
**en ce que** le conducteur (10) de point neutre est relié au potentiel de terre par un câble (11) de mise à la terre,
dans lequel le câble (11) de mise à la terre est équipé d'un capteur (15) de courant.
